Europäisches Patentamt

European Patent Office

Office européen des brevets

(11) Veröffentlichungsnummer: **0 281 001**
**A2**

## (12) EUROPÄISCHE PATENTANMELDUNG

(21) Anmeldenummer: **88102665.2**

(22) Anmeldetag: **24.02.88**

(51) Int. Cl.⁴ **H03M 1/06 , H03M 1/66**

(30) Priorität: **28.02.87 DE 3706508**
**20.03.87 DE 3709207**

(43) Veröffentlichungstag der Anmeldung:
**07.09.88 Patentblatt 88/36**

(84) Benannte Vertragsstaaten:
**AT BE CH DE ES FR GB IT LI NL SE**

(71) Anmelder: **Standard Elektrik Lorenz**
**Aktiengesellschaft**
**Lorenzstrasse 10**
**D-7000 Stuttgart 40(DE)**

(84) **DE**

(71) Anmelder: **Alcatel N.V.**
**Strawinskylaan 537 (World Trade Center)**
**NL-1077 XX Amsterdam(NL)**

(84) **BE CH ES FR GB IT LI NL SE AT**

(72) Erfinder: **Reiber, Hans**
**Holzhauser Strasse 32**
**D-7000 Stuttgart 80(DE)**

(74) Vertreter: **Pohl, Heribert, Dipl.-Ing et al**
**Standard Elektrik Lorenz AG Patent- und**
**Lizenzwesen Postfach 30 09 29**
**D-7000 Stuttgart 30(DE)**

(54) Schaltungsanordnung zum Umwandeln von digitalen Tonsignalwerten in ein analoges Tonsignal.

(57) Diese Schaltungsanordnung weist ein Interpolationsfilter (3) auf, in dem die ankommenden Signalwerte (A) in interpolierte Signalwerte (B) mit erhöhter Folgefrequenz (Üxfs) umgesetzt werden. Die Signalwerte (B) werden mittels Quantisierer (4a), Quantisierungsfehlerrückführung und Fehlerfilter (25) in der Vortlänge reduziert. Ein D/A-Wandler (6) besteht aus mehreren parallelliegenden, nichtgewichteten Schaltstufen. Die jeweils aktivierten Schaltstufen geben Teilströme ab, die ausgangsseitig addiert werden. Der D/A-Wandler (6) wird von einer Ansteuerschaltung (5) gesteuert, die die Ausgangsignale (D) des Interpolationsfilters (3) verarbeitet. Die aktivierten Schaltstufen werden laufend zyklisch vertauscht, so daß sich relative Widerstandstoleranzen in der Schaltungsanordnung im Mittel ausgleichen.

Fig. 5

## Schaltungsanordnung zum Umwandeln von digitalen Tonsignalwerten in ein analoges Tonsignal

Die Erfindung betrifft eine Schaltungsanordnung zum Umwandeln von digitalen Tonsignalwerten in ein analoges Tonsignal, die folgende Merkmale aufweist:

a. Ein Interpolationsfilter, in dem die ankommenden Signalwerte in eine Folge interpolierter Signalwerte mit einer erhöhten Folgefrequenz umgesetzt werden,

b. eine Reduktionsschaltung, durch die die Wortlänge der interpolierten Signalwerte verringert wird, und die aus einem Quantisierer, einem Fehlerfilter und einer Addierstufe besteht,

c. ein Digital-Analog-Wandler,

c.c der aus mehreren nicht gewichteten Schaltstufen besteht, deren Teilströme ausgangsseitig addiert werden,

d. eine Ansteuerschaltung, durch die aufgrund der digitalen Signalwerte am Ausgang des Quantisierers die Schaltstufen derart gesteuert werden, daß die Summe der ausgegebenen Teilströme dem jeweils anliegenden Signalwert entspricht und die dabei aktivierten Schaltstufen durch zyklische Weiterschaltung ausgewählt werden, und

e. eine dem Digital-Analog-Wandler nachgeschalteter Tiefpaß, an dessen Ausgang das Analogsignal abgegeben wird.

Die Merkmale a, b, c und e sind aus der älteren Anmeldung P 36 17 433.5 (internes Aktenzeichen: H.Reiber 15X) bekannt, die Merkmale c.c und d bilden den kennzeichnenden Teil des Hauptanspruchs.

Bei der Schaltungsanordnung nach der älteren Anmeldung sind die Anforderungen an die Genauigkeit des Digital-Analog-Wandlers gegenüber nichtinterpolativen Wandlersystemen beträchtlich herabgesetzt, sie sind aber für eine Realisierung in CMOS-Halbleitertechnik noch schwer zu erfüllen.

Aus IEEE Journal of Solid-State-Circuits, Vol. Sc-21, No.6, December 1986 ist ein Digital-Analog-Wandler (D/A-Wandler) in CMOS bekannt, die mit 65 Schaltstufen versehen ist, die jeweils aus einer Stromquelle und einem Schalter bestehen. 63 dieser Schaltstufen sind nicht gewichtet, sie sind matrixförmig angeordnet, während die zwei niedrigwertigsten Schaltstufen entsprechend ihrer binären Wertigkeit gewichtet sind. Um den Einfluß der relativen Abweichungen der einzelnen Schaltstufen untereinander auf den Störabstand der Schaltungsanordnung zu verringern, werden die Schaltstufen in symmetrischer Reihenfolge angesteuert.

Aus der Druckschrift der Firma Intermetall: DIGIT 2000, VLSI Digital TV System, S.106 ist ein interpolativer D/A-Wandler bekannt, mit dem zwei digitalisierte Signalwertefolgen eines Stereotonsignals in pulsweitenmodulierte Tonsignale für den rechten und den linken Stereokanal umgewandelt werden. Mit diesem Wandler wird ein Störabstand von ca. 75 dB erreicht.

Der Erfindung liegt die Aufgabe zugrunde, eine Schaltungsanordnung zur Digital-Analog-Umwandlung von Tonsignalen zu schaffen, die einen hohen Störabstand aufweist.

Diese Aufgabe wird erfindungsgemäß durch die Schaltungsanordnung nach Patentanspruch 1 gelöst.

Vorteile der erfindungsgemäßen Schaltungsanordnung sind insbesondere, daß sie sich in CMOS-Technik gut integrieren läßt und daß sie für hochwertige Endgeräte mit digitaler Tonverarbeitung geeignet ist.

Vorteilhafte Weiterbildungen der Erfindung sind in den Unteransprüchen gekennzeichnet.

Ausführungsbeispiele der Erfindung werden im folgenden anhand der Zeichnung erläutert. Es zeigen:

Fig. 1 eine Schaltungsanordnung gemäß der Erfindung mit interpolativer D/A-Wandlung, als Blockschaltbild dargestellt,

Fig. 2 ein in der Schaltungsdanordnung nach Fig. 1 verwendbarer D/A-Wandler,

Fig. 3 ein anderer in der Schaltungsanordnung nach Fig. 1 verwendbarer D/A-Wandler,

Fig. 4 ein Beispiel der Ansteuerung für einen acht Schaltstufen aufweisenden D/A-Wandler der Schaltungsanordnung nach Fig. 1, als Prinzipdarstellung,

Fig. 5 ein detailliertes Ausführungsbeispiel einer erfindungsgemäßen Schaltungsanordnung mit interpolativer D/A-Wandlung,

Fig. 6 den für eine erfindungsgemäße Schaltungsanordnung ermittelten Störabstand in Abhängigkeit von der Aussteuerung,

Fig. 7 ein erstes Ausführungsbeispiel einer Ansteuerschaltung für die Schaltungsanordnung nach Fig. 5,

Fig. 8 ein zweites Ausführungsbeispiel einer Ansteuerschaltung für die Schaltungsanordnung nach Fig. 5,

Fig. 9 ein drittes Ausführungsbeispiel einer Ansteuerschaltung für die Schaltungsanordnung nach Fig. 5,

Fig.10 11, 12 verschiedene Impulsausgabeformen des D/A-Wandlers einer erfindungsgemäßen Schaltungsanordnung mit einer Reduktionsschaltung nach Fig.13, und

Fig.13 eine Reduktionsschaltung, mit der in der Schaltungsanordnung nach Fig. 5 die Zahl der Quantisierungsstufen verringert werden kann.

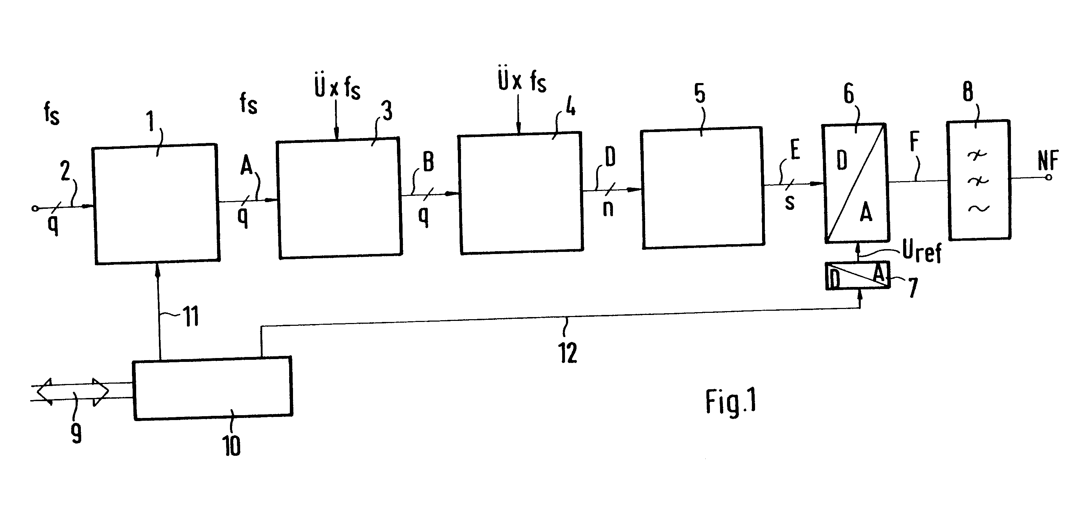

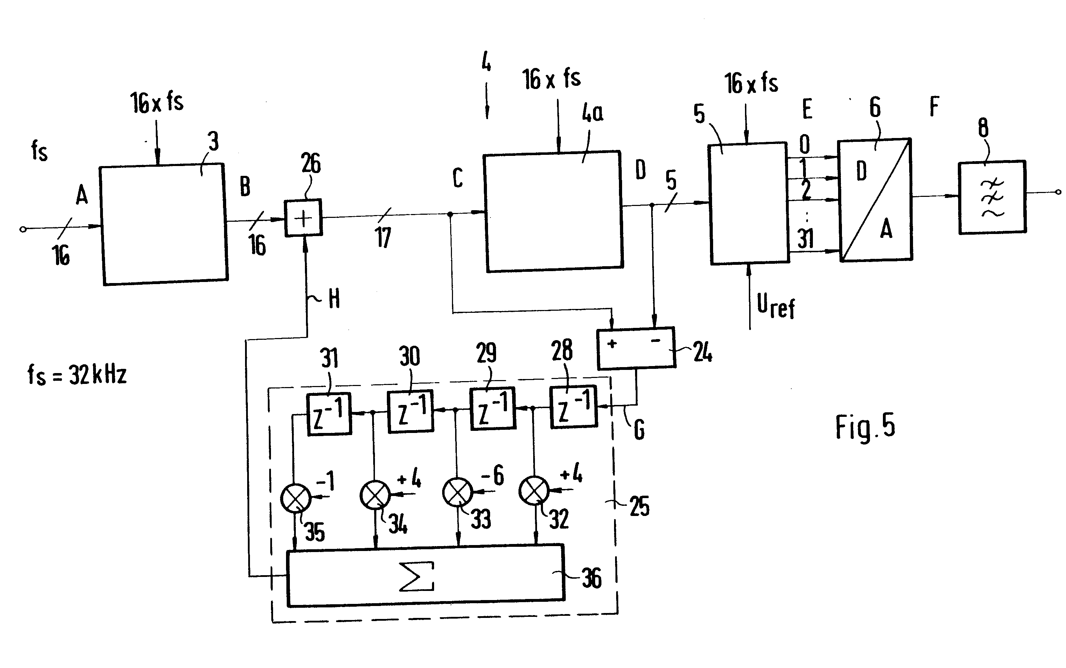

In einer Klangsteuerung 1, die aus einer programmierbaren ALU mit internen ROM-und RAM-Speichern besteht, werden die über eine Eingangsleitung ankommenden Ton-Signalwerte in der Lautstärke, Balance, den Höhen und den Tiefen digital verstellt (Fig. 1). Entsprechend der Anzahl q Bits, aus denen die eingehenden digitalen Signalwerte oder "Worte" bestehen, weist die Eingangsleitung 2 q parallele Adern auf. In dem Ausführungsbeispiel ist q = 16, d.h. die Tonsignale sind mit 16 Bit quantisiert. Ihre Abtastfrequenz $f_s$ beträgt eingangsseitig 32 kHz. Die interne Wortbreite in der Klangsteuerung 1 beträgt 24 Bit. Über eine Leitung A gelangen die Signalwerte mit q = 16 Bit dann zu einem Interpolationsfilter 3, das ein mit einem Überabtastfaktor Ü überabgetastetes Ausgangssignal erzeugt. In dem Ausführungsbeispiel ist Ü = 16. Uber eine Leitung B (die Buchstaben A, B, ... werden im folgenden sowohl zum Bezeichnen der Leitungen wie auch der über sie übertragenen Signalwerte benutzt) gelangen die Signalwerte zu einer Reduktionsschaltung 4, in der ihre Wortlänge durch Quantisierung und Quantisierungsfehlerrückführung von sechzehn auf fünf Bit reduziert wird. Einzelheiten hierzu werden anhand von Fig. 5 erläutert.

Über eine Leitung D gelangen Signalwerte mit einer Wortbreite n (z.B. n = 5) zu einer Ansteuerschaltung 5, wo sie umcodiert und in Form von s (im Beispiel s = 32) parallelen Bits an einen D/A-Wandler 6 übertragen werden. Das Ausgangssignal dieses Wandlers gelangt über eine Leitung F zu einem Tiefpaß 8 und verläßt diesen dann als niederfrequentes Tonsignal NF. Dargestellt ist hier nur einer der beiden Stereoton-Kanäle.

Die über einen Steuerbus 9 ankommenden Steuersignale gelangen über eine Schnittstellenschaltung 10 und eine erste Steuerleitung 11 zu der Klangsteuerung 1, in der die Lautstärke und die anderen genannten Tonparameter digital gesteuert werden. Über eine zweite Steuerleitung 12 gelangt ebenfalls ein digitales Steuersignal zu einem weiteren D/A-Wandler 7, an dessen Ausgang eine gesteuerte Bezugsspannung $U_{ref}$ für den multiplizierenden D/A-Wandler 6 abgegeben wird. Hierbei wird die Lautstärke analog nachverstellt. Im Vergleich zur rein digitalen Lautstärkeeinstellung, bei der mit zunehmender Abschwächung die Quantisierung grober wird, bewirkt die analoge Nachverstellung eine Verbesserung des Störabstandes bei reduzierter Lautstärke.

Anstelle eines normalen D/A-Wandlers 7 kann hier auch ein Impulsbreitenmodulator oder ein Impulsdichtemodulator angewandt werden. Zur Glättung der Referenzspannung $U_{ref}$ ist dann am Ausgang des D/A-Wandlers 7 ein Siebglied vorzusehen.

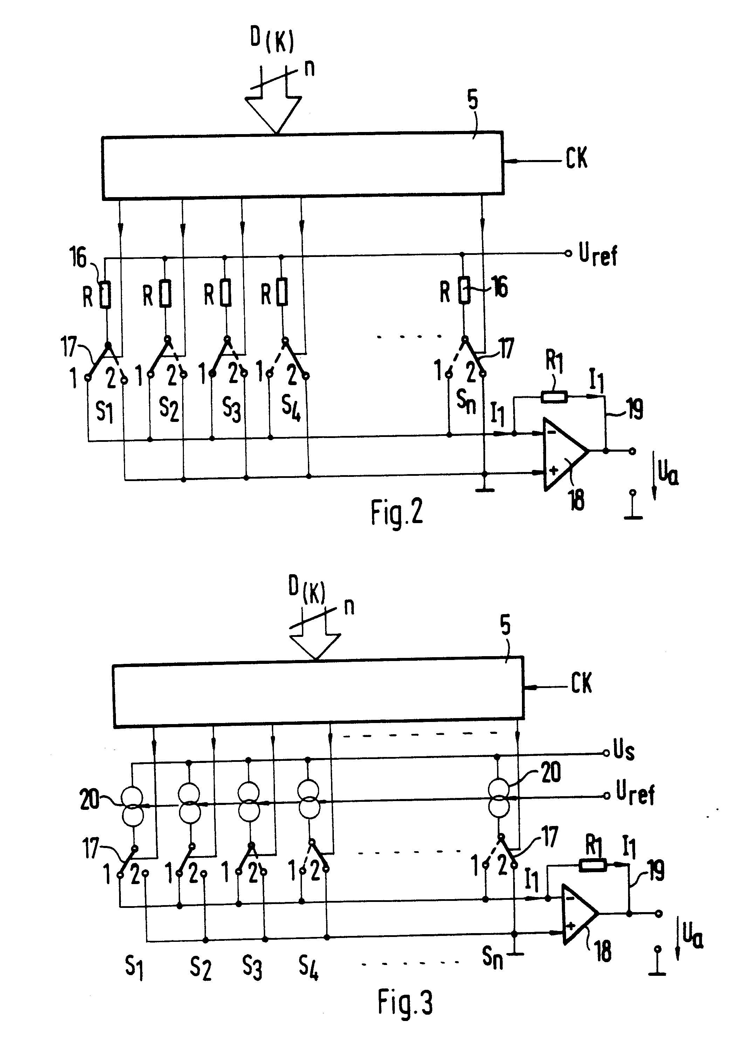

Die der Ansteuerschaltung 5 zugeführte Signalwertefolge D(K) - K ist der Folgeindex - wird in dieser decodiert (Fig. 2). Die dabei erzeugten Schaltsignale steuern mehrere parallel angeordnete Schaltstufen, die jeweils aus einem in Reihe mit einem Widerstand 16 liegenden Schalter 17 bestehen. Der an einer Bezugs-oder Referenzspannung $U_{ref}$ liegende Widerstand 16 wird durch den Schalter 17 in einer Schalterstellung 1 mit dem invertierenden Eingang eines Operationsverstärkers 18 und in der Schalterstellung 2 mit dessen nicht invertierendem und an Masse liegenden Eingang verbunden. Der Ausgang des Operationsverstärkers 18 ist durch einen Widerstand R1 enthaltenden Gegenkopplungszweig 19 mit seinem invertierenden Eingang verbunden.

Die Widerstände 17 sind hier nicht wie bei herkömmlichen D/A-Wandlern nach dem Verhältnis der binären Wertigkeiten ($1 : 2 : 4 : ... : 2^N$) gewichtet sondern haben alle den gleichen Widerstandswert. Zur Darstellung von $2^N$ Amplitudenwerten sind daher auch $2^N-1$ Schalter erforderlich. Der Ausgangsstrom I1 hängt somit von der Zahl der auf Schalterstellung 1 stehenden Schaltstufen ab.

Die erwähnte analoge Nachverstellung der Lautstärke wird durch Verändern der Bezugsspannung $U_{ref}$ mit dem Ausgangssignal des D/A-Wandlers 7 (Fig. 1) gesteuert. Die Zahl der Schaltstufen läßt sich, wie anhand von Fig. 1 schon erwähnt, durch Vorschalten einer Einrichtung zur Wortlängenreduktion mit Überabtastung und Quantisierungsfehlerrückführung auf Werte von 8 bis 31 reduzieren. Solche Einrichtungen verringern allerdings nicht die Genauigkeitsanforderung an die D/A-Wandlung. Um beispielsweise ein 16-Bit-System mit dem entsprechenden Störabstand von 98 dB zu realisieren, muß der D/A-Wandler nach der Wortlängenreduktion zwar nur noch wenige Quantisierungsstufen aufweisen. Die Genauigkeit (Linearität) der Quantisierungsstufen muß jedoch annähernd der eines echten 16-Bit-D/A-Wandlers entsprechen. Auch bei der Schaltungsanordnung nach der erwähnten älteren Patentanmeldung, bei der mit einem D/A-Wandler relativ niedriger Linearität ein guter Störabstand erreicht wird, ist immer noch eine relativ hohe Genauigkeit erforderlich.

Mit der anhand der nachfolgenden Figuren beschriebenen Art der Ansteuerung ist auch bei einer hohen relativen Abweichung der Widerstandswerte R der Widerstände 16 von bis zu 0,5 Prozent noch ein Störabstand von etwa 95 dB realisierbar.

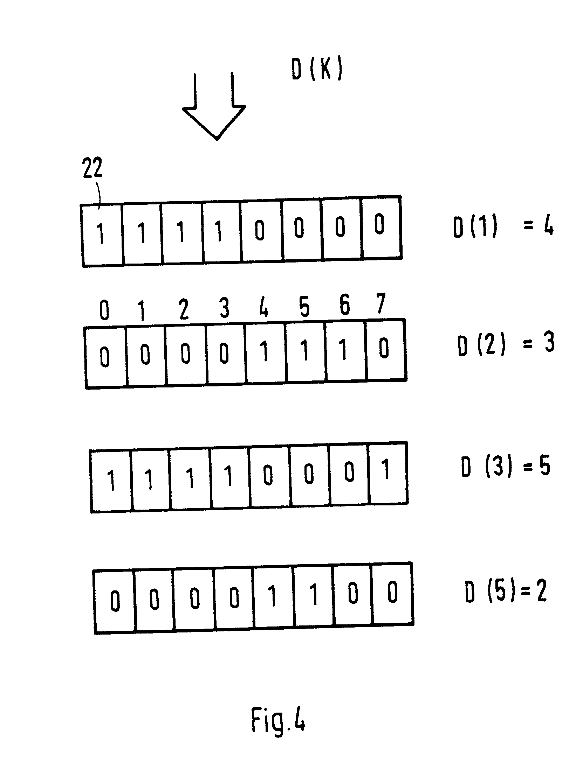

Entsprechendes gilt für die Decodier-und D/A-Wandlerschaltung nach Fig. 3. Diese unterscheidet sich von der nach Fig. 2 nur dadurch, daß die Widerstände der parallelen Schaltstufen durch Einzel-Stromquellen 20 ersetzt sind. Auch bei diesen soll eine maximale relative Abweichung von etwa 0,5% zugelassen werden.

Eine Speisespannung $U_s$ für die Stromquellen 20 ist konstant. Zur analogen Nachverstellung der Lautstärke wird den einzelnen Stromquellen 20 eine Steuerspannung $U_{ref}$ zugeführt, die von dem Ausgangssignal des D/A-Wandlers 7 bestimmt wird.

Das Ziel, hohe relative Abweichungen der Einzelfunktionen · zuzulassen, läßt sich erreichen, indem bei der Ausgabe der aufeinanderfolgenden Amplitudenwerte des Tonsignals die Auswahl der Schalter zyklisch erfolgt. Fig. 4 zeigt schematisch ein Beispiel eines D/A-Wandlers mit acht Schaltern 17, deren Stellungen als Kästchen 22 dargestellt sind. Die von der Reduktionsschaltung 4 ankommenden Signal-Amplitudenwerte $D(1) = 4$, $D(2) = 3$, $D(3) = 5$ und $D(4) = 2$ sollen nacheinander durch den D/A-Wandler ausgegeben werden.

Der erste Amplitudenwert "4" wird hier beispielsweise durch das Einschalten der ersten vier Widerstände (oder Stromquellen) über die Schalter 17 - S1 bis S4 -durchgeschaltet, d.h. beginnend mit dem Schalter S1 werden die ersten vier Schalter auf Stellung 1 gebracht. Der folgende Amplitudenwert "3" erfolgt durch Einschalten der Schalter S5 bis S7 und Ausschalten der Schalter S1 bis S4. Beim nächsten Amplitudenwert "5" wird der letzte Schalter S8 und zyklisch nachfolgend die ersten vier Schalter S1 bis S4 eingeschaltet. Danach werden die Schalter S5 und S6 zur Ausgabe des Amplitudenwertes "2" usw. durchgeschaltet. Durch den zyklischen Wechsel der Schalter wird erreicht, daß die wegen der Abweichungen der einzelnen Bauteile unvermeidlichen Amplitudenschwankungen sich im statistischen Mittel aufheben. D.h., die Integration der Abweichungen strebt mit der Zeit gegen Null.

Die toleranzbedingten Abweichungen der Amplitudenwerte bewirken ein Störspektrum, das bei einem D/A-Wandlersystem mit Überabtastung weit über den Hörbereich hinausgeht. Der durch die Toleranz der Bauelemente bedingte, auf den Hörbereich bezogene Störabstand nimmt mit zunehmendem Überabtastfaktor Ü zu.

Der Aufbau des D/A-Wandlers aus unter sich gleichen Widerständen oder Stromquellen ergibt gegenüber dem herkömmlichen Prinzip der nach der binären Wertigkeit gewichteten Widerstände oder Teilströme bereits eine Verbesserung des Störabstands um $2^n$ bei gleicher prozentualer Bauteile-Toleranz (n = Wortbreite). Es ist somit einzusehen, daß mit der erfindungsgemäßen D/A-Wandlerschaltung mit zyklischer Schalterbetätigung in Verbindung mit einer Wortlängenreduktionseinrichtung ein sehr hoher Störabstand erreicht wird.

Die aus Fig. 5 ersichtliche Schaltungsanordnung mit interpolativer D/A-Wandlung ist mit einer Wortlängen-Reduktionsschaltung 4 mit Überabtastung und Quantisierungsfehlerrückführung versehen. Schaltungsbestandteile, die anhand von Fig. 1 bereits beschrieben worden sind, werden hier nicht nochmals eingehend erläutert.

Der Ausgang des Interpolationsfilters 3 ist über eine Addierstufe 26 mit dem Eingang eines Quantisierers 4a verbunden. In dem Quantisierer 4a werden die von der Addierstufe 26 kommenden Signalwerte C in der Wortbreite reduziert, so daß am Ausgang Parallelworte mit $n = 5$ Bit abgegeben werden.

In einer Differenzschaltung 24 wird eine Quantisierungsfehlerfolge G gebildet, indem von den Eingangssignalen C die Ausgangssignale D des Quantisierers 4a unter Berücksichtigung ihrer Wertigkeit subtrahiert werden. In dem Ausführungsbeispiel entsprechen die Quantisierungsfehlerwerte den abgetrennten niederwertigen Bits der Eingangssignale C. In einem Fehlerfilter 25 werden aus den Quantisierungsfehlerwerten G Rückkopplungswerte H gebildet, die in der Addierstufe 26 zu den Ausgangssignalwerten B am Ausgang des Interpolationsfilters 3 addiert werden und dabei die Eingangssignalwerte C des Quantisierers 4a ergeben. Die an sich bekannte Quantisierungsfehlerrückkopplung bewirkt bei entsprechendem Zeitverhalten des Fehlerfilters 25, daß der im Hörbereich liegende Anteil des Quantisierungs-Störspektrums am Ausgang D der Reduktionsschaltung 4 zu höheren Frequenzen, d.h. außerhalb des Hörbereichs, verschoben wird.

Das dargestellte Fehlerfilter 25 ist vierten Grades. Die Quantisierungsfehlerwerte G durchlaufen nacheinander vier Verzögerungsglieder 28, 29, 30 und 31. Deren Ausgangssignale werden jeweils einem Multiplizierer 32, 33, 34 bzw. 35 zugeführt, in diesen mit den Faktoren $+4$, $-6$, $+4$, $-1$ multipliziert und dann einem Addierer 36 zugeführt. Die Ausgangssignale dieses Addierers 36 stellen die Rückkopplungswerte H dar, die der Addierstufe 26 zugeführt werden.

Bei Anwendung eines solchen Fehlerfilters von viertem Grad kann die Wortlänge von 16 auf theoretisch 4 Bit reduziert werden. Das Fehlerfilter verursacht jedoch Überschwingungen, die es zweckmäßig erscheinen lassen, das Eingangswort des Reduktionsschaltungs 4 von 16 auf 17 Bit und sein Ausgangswort von 4 auf 5 Bit zu erhöhen. Der Ausgang des Decoders 6 weist somit 32 Anschlüsse 0 bis 31 auf, die die Schaltstufen des D/A-Wandlers 7 in der beschriebenen Weise steuern.

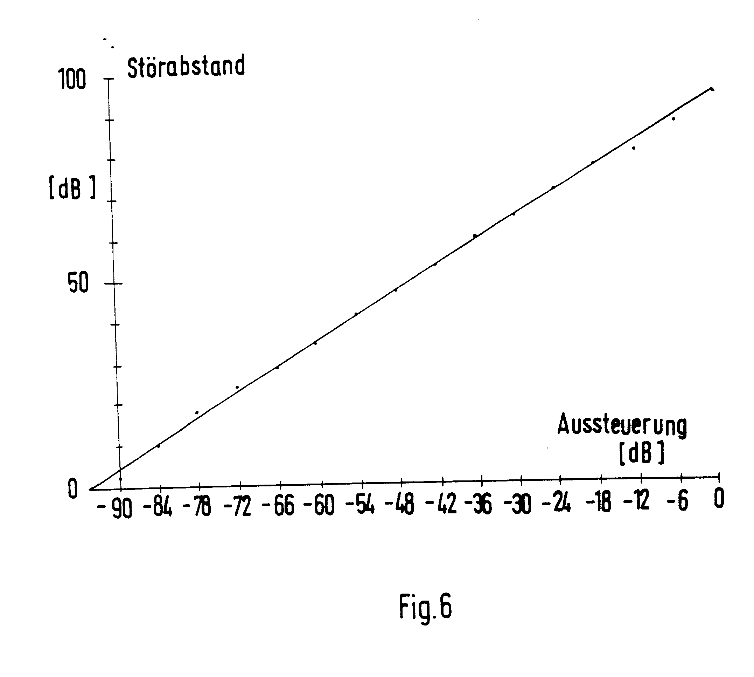

In dem Diagramm von Fig. 6 ist der für die erfindungsgemäße Schaltungsanordnung ermittelte Störabstand in dem Fall, daß auf der Leitung A eine sinusförmige Wertefolge anliegt, in Abhängigkeit von der Aussteuerung dargestellt. Der maximale Störabstand bei Vollaussteuerung beträgt etwa 95 dB. Dieser Wert gilt für Widerstandstoleranzen von etwa 0,5%. Der theoretische Höchstwert eines 16-Bit-Systems beträgt 98 dB.

Die Ausgabefrequenz des pulsamplitudenmodulierten Signals liegt mit 512 kHz deutlich unter der Impulsausgabefrequenz des bekannten Pulsdichtemodulation-Verfahrens - Ein-Bit-Wandler-Prinzip - von etwa 8 MHz. Daraus ergibt sich ein geringerer Leistungsverbrauch des erfindungsgemäßen Verfahrens. Durch die geringere Ausgabefrequenz sind auch die durch den Flankenjitter und das Energieübersprechen bei zeitlich direkt aufeiannderfolgenden Impulsen verursachten Probleme geringer als bei dem PDM-Verfahren. Im Vergleich zu handelsüblichen D/A-Wandlern mit binärgewichteten Widerstands-oder Stromquellen-Netzwerken ist die "Glitch"-Energie wesentlich geringer, da die Stromquellen niemals alle gleichzeitig ein-und ausschalten. Die bei der Impulsbreiten-Modulation auftretenden Zeitfehler, die ein zusätzliches Störspektrum erzeugen können, entfallen hier. Bei der multiplikativen D/A-Wandlung ist eine analoge Nachverstellung der Lautstärke und der Balance durch Variation der Referenzspannung möglich, wodurch, wie bereits erwähnt, der Störabstand bei reduzierter Lautstärke verringert werden kann.

Wegen der für die Einzelwiderstände oder -stromquellen zulässigen hohen relativen Toleranzen von etwa 0,5% ist die erfindungsgemäße Schaltungsanordnung für eine CMOS-Integration geeignet.

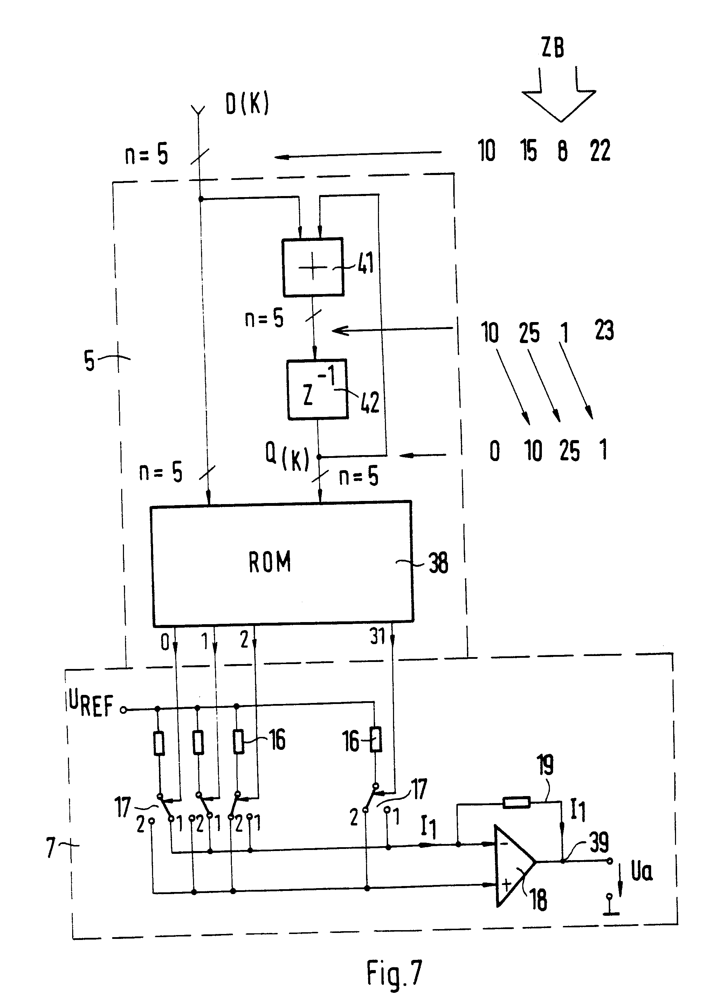

Das aus Fig. 7 ersichtliche Ansteuerschaltung 5 für einen D/A-Wandler 6 enthält einen ROM-(d.h. einen Nur-Lese-) Speicher 38. Eine durch den jeweils anliegenden Signalwert $D(K)$ bestimmte Zahl von Schaltern 17 wird ab einer Anfangsmarke auf Stellung 1 gebracht und ergibt an einem Summierungspunkt 39 den entsprechenden Gesamtstrom I1. Die Anfangsmarke wird durch Akkumulation der Eingangswerte $D(K)$ gebildet, und zwar in einem Akkumulator, der aus einem Addierer 41 mit der Wortbreite n des Eingangsworts D und aus einem Verzögerungsglied 42 besteht.

Die Eingangswerte $D(K)$ und die Akkumulator-Ausgangswerte $Q(K)$ bilden Teiladressen für den ROM-Speicher 38. Dieser Speicher enthält Zuordnungstabellen für die Decodierung der Eingangswerte und die zyklische Schaltersteuerung.

Auf der rechten Seite von Fig. 7 ist die Wirkungsweise des Akkumulators 41, 42 anhand eines Zahlenbeispiels ZB verdeutlicht.

Die Zahl der Speicherstellen des ROM-Speichers beträgt $p = 2^{3n}$. Für $n = 5$ ist $p = 2^{15}$. Dies ist eine relativ hohe Anzahl Speicherstellen und erfordert somit eine große Fläche auf einem Halbleiterchip.

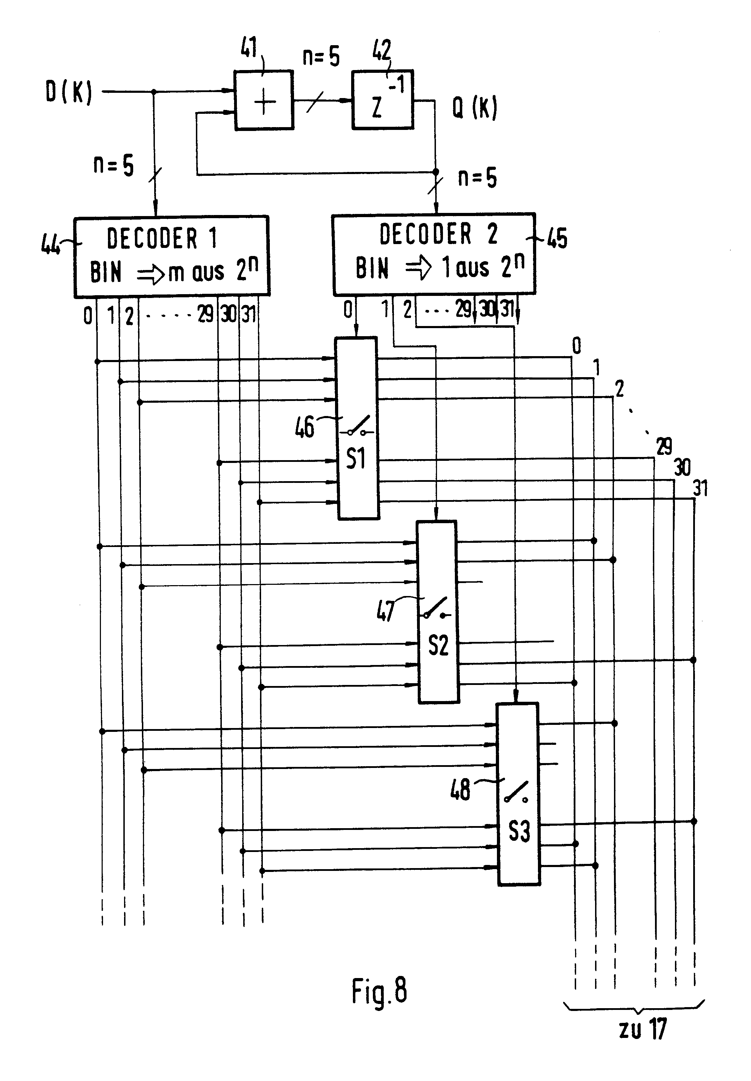

Das aus Fig. 8 ersichtliche Ausführungsbeispiel einer Ansteuerschaltung für einen D/A-Wandler weist ebenfalls einen aus einem Addierer 41 und einem Verzögerungsglied 42 bestehenden Akkumulator auf. Anstelle des ROM-Speichers ist es mit zwei Decodern 44 und 45 versehen. Der Decoder 44 wandelt die binären Werte $D(K)$ in einen Code m aus $2^n$ um. Ist beispielsweise der Eingangswert $D(1) = 4$, so sind seine Ausgänge 0 bis 3 auf logisch 1 und die übrigen auf logisch 0 geschaltet. Bei $D(2) = 3$ liegen seine Ausgänge 0 bis 2 auf logisch 1. Bei $D(3) = 0$ sind alle Ausgänge auf 0 geschaltet. Der Decoder 45 bildet aus den akkumulierten parallelen Eingangsworten die Anfangsmarke in einen Code 1 aus $2^n$.

Sämtliche Ausgänge des Decoders 44 werden über einen Bus auf $2^n$ Schalterblöcke 46, 47, 48, ... geführt, die ihrerseits je $2^n$ Einzelschalter - durch einen Schalter Sn symbolisch dargestellt - enthalten. Alle Einzelschalter eines Schaltblocks 46, 47 48, ... werden gemeinsam über eine Steuerleitung von dem Decoder 45 gesteuert.

Die Ausgänge der untereinander liegenden Schalterblöcke 46, 47, 48, ... werden mit einem fortlaufenden zyklischen Versatz auf einen Steuerbus geschaltet, der die Stromschalter 17 des D/A-Wandlers 7 (in Fig. 8 nicht dargestellt) ansteuert. Es wird somit nur einer der Schalterblöcke mit einen der decodierten Anfangsmarke entsprechenden zyklischen Versatz auf den Ausgangsbus geschaltet. Daraus ergibt sich das bereits anhand von Fig. 4 erläuterte zyklische Weiterschalten der Stromquellen des D/A-Wandlers entsprechend dem jeweiligen digitalen Eingangswert.

Die Zahl der Einzelschalter beträgt bei dem Beispiel von Fig. 8 $2^{2n}$ und ist somit um den Faktor n mal geringer als die Zahl der Speicherstellen des ROM-Speichers 38. Da pro Schaltfunktion nur ein Transfer-Gate mit zwei MOS-Transistoren notwendig ist, ergibt sich hier bereits eine beträchtliche Verringerung des Schaltungsaufwands.

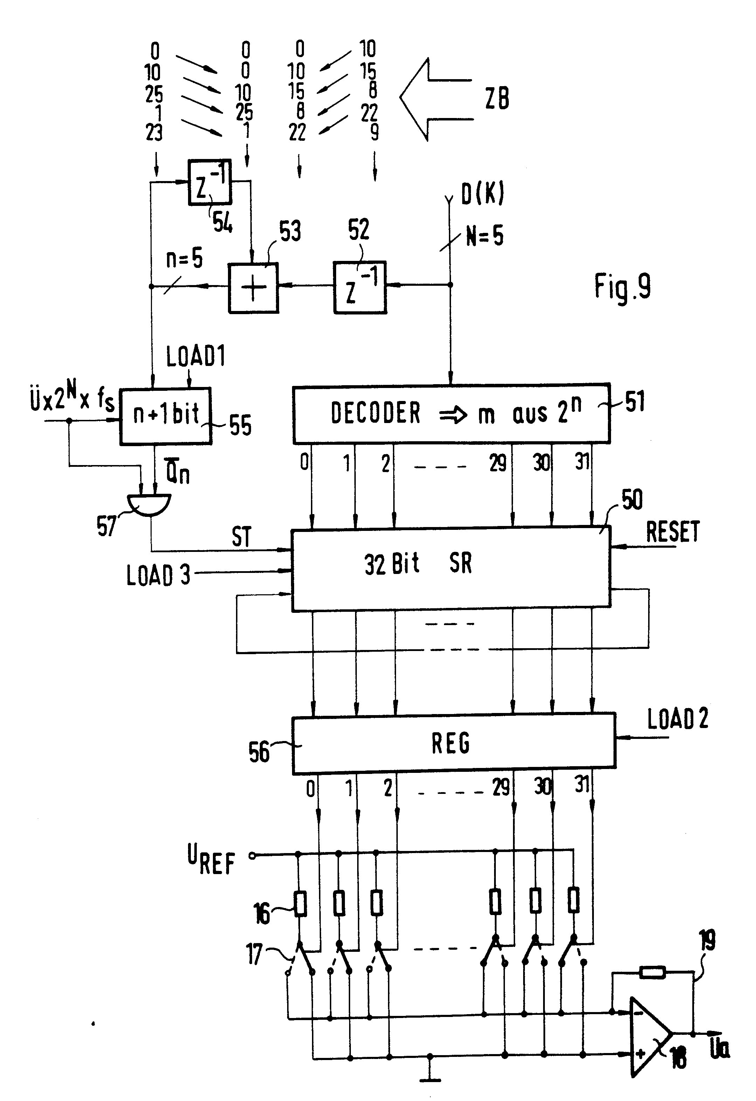

Die aus Fig. 9 ersichtliche Ansteuerschaltung weist ein als Ringzähler arbeitendes Schieberegister 50 auf, das von einem Decoder 51 parallel gesetzt wird, der eine m aus $2^n$-Decodierung durchführt. Die Eingangsdaten gelangen auch über ein Verzögerungsglied 52 zu einem aus einem Addierer 53 und einem weiteren Verzögerungsglied 54 bestehenden Akkumulator. Der jeweils um einen Taktzyklus verzögerte und akkumulierte $n = 5$ Bit breite Ausgangswert des Akkumulators wird einem $(n+1)$-Bit-Rückwärtszähler 55 mit parallelen Dateneingängen zugeführt, wobei die Datenübernahme durch ein Steuersignal LOAD1 erfolgt. Durch eine Und-Verknüpfung des höchstwertigen Datenausgangs $\bar{Q}_n$ mit dem Eingangstakt des Zählers in einem UND-Gatter 57 entstehen am Ausgang des UND-Gatters 57 serielle Impulse mit der gegenüber der Datenrate der Eingangsdaten D $2^n$-fachen Frequenz. Bei Unterschreiten des Zählwertes null wird das Gatter 55 gesperrt. Die Impulszahl entspricht somit dem Wert des Parallelwerts am Ausgang des Akkumulators, d.h. es erfolgt eine Parallel/Seriell-Wandlung. Das serielle Ausgangssignal des UND-Gatters 57 bildet den Schiebetakt des Ringzählers 50, so daß die mit dem Steuersignal LOAD3 neu geladenen Daten D(K) um den akkumulierten Zählwert nach rechts verschoben werden. Nach Beendigung des Schiebevorgangs wird der Inhalt des Schieberegisters 50 in ein Register 56 eingeschrieben, dessen Ausgänge die Schaltstufen 16, 17 des D/A-Wandlers steuern. Bevor der Ringzähler erneut mit dem neuen Eingangswort D-(K) parallel gesetzt wird, werden alle seine Speicherzellen mit einem RESET-Impuls auf Null zurückgesetzt.

Dieses Ausführungsbeispiel zeichnet sich durch einen besonders geringen Speicheraufwand aus, erfordert allerdings gegenüber den beiden vorher beschriebenen Ausführugnsbeispielen eine um den Faktor $2^n$-höhere Schiebetaktfrequenz.

Durch ein auf Fig. 9 oben dargestelltes Zahlenbeispiel ZB wird die Wirkungsweise der Verzögerung und Akkumulierung der Eingangswerte D(K) verdeutlicht.

Zur Darstellung eines 5-Bit-Worts genügen an sich $2^5-1 = 31$ geschaltete Widerstände, denn für den Wert 0 wird keine Stromquelle benötigt. Um jedoch die üblichen Akkumulatorgrundschaltungen anwenden zu können, sind in den Figuren 7, 8 und 9 32 Schaltstufen vorgesehen, von denen jedoch maximal 31 gleichzeitig aktiviert werden.

Unter Anwendung einer speziellen Akkumulatorschaltung, die bereits eine Zählstufe früher auf Null statt auf 31 springt und bei Addition einer Zahl x mit 31 das akkumulierte Ergebnis x liefert, kann durchaus eine entsprechende Decodierschaltung mit nur 31 Ausängen gebildet werden.

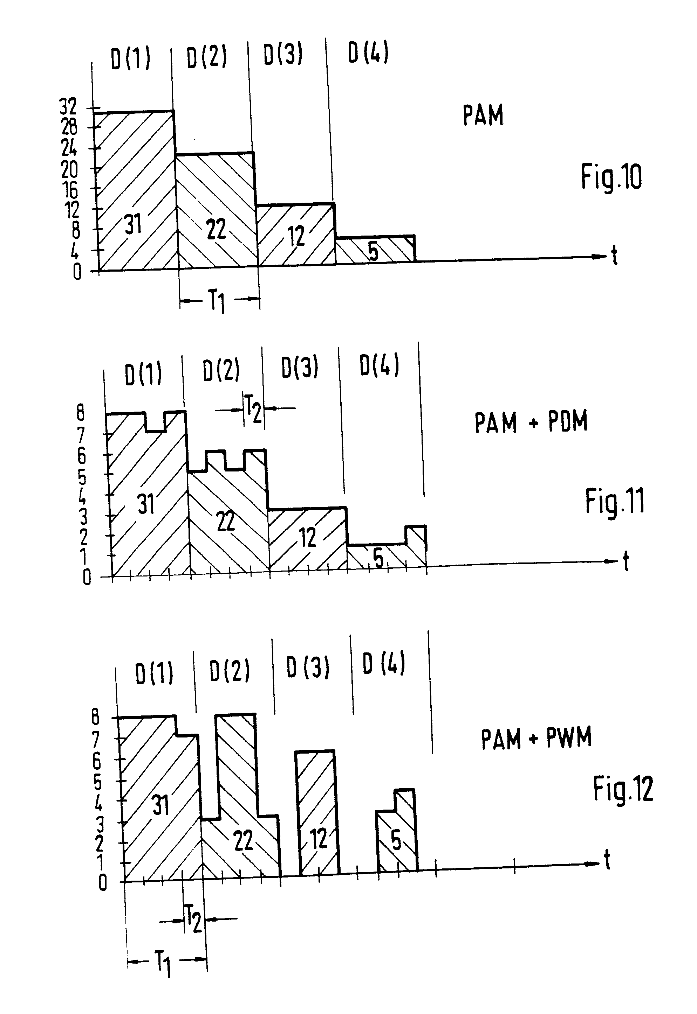

Anhand der Figuren 10 bis 13 wird nun ein Verfahren erläutert, mit dem die Zahl der Quantisierungsstufen des D/A-Wandlers verringert und dadurch der Bedarf an Chipfläche insbesondere bei der Verwendung von geschalteten Widerständen reduziert wird. Der Flächenbedarf steigt z.B. bei Poly-Silicium-Widerständen mit zunehmender Genauigkeitsanforderung und zunehmendem Widerstandswert.

Theoretisch kann eine Reduktion der benötigten Quantisierungsstufenzahl durch eine weitere Erhöhung des Überabtastfaktors erreicht werden. Dies hat jedoch eine beträchtliche Erhöhung des Schaltungsaufwandes beim Interpolationsfilter zur Folge. Deshalb ist der nachfolgend beschriebene Weg zweckmäßiger.

Die aus Fig. 10 ersichtliche Impulsausgabeform des D/A-Wandlers stellt die in den vorstehend erläuterten Ausführungsbeispielen verwendete reine Pulsamplitudenmodulation dar. Als Beispiel sind die Amlitudenwerte D(1) = 31, D(2) = 22, D(3)-= 12 und D(4) = 5 dargestellt.

In Fig. 11 wird jeder Ausgabewert durch vier Teilimpulse unterschiedlicher Höhe dargestellt. Die Impulsfrequenz vervierfacht sich also. Für die Teilimpulse werden jedoch nur die Quantisierungsstufen 0 bis 8 und somit auch nur acht Schaltstufen benötigt. Die flächenmäßige Quantisierung ist allerdings 4 . 8 = 32. Bei einem 5-Bit-Eingangswort werden von den 32 maximal möglichen Flächenelementen allerdings nur 31 ausgenützt. Die 32. Quantisierungsstufe entspricht dem Digitalwert 0, der kein Flächenelement aktiviert. Die Lage der um einen Quantisierungschritt kleineren oder größeren Teilimpulse sollte so verteilt sein, daß das durch ihre Zeitfehler verursachte Störspektrum im Hörbereich ein Minimum bildet. Diese Impulsausgabeform entspricht einer Kombination von Pulsamplituden-und Pulsdichtemodulation.

Fig. 12 zeigt eine weitere Ausgabeform der Teilimpulse eines Impulspaketes, die einer Kombination aus Pulsamplituden-und Pulsbreitenmodulation entspricht. Die Abtastfrequenz 1/T1 ist hier stärker ausgeprägt als bei den Figuren 10 und 11. Es ist deshalb ein höherpoliges Nachfiltern notwendig. Auch die Zeitfehler sind bei dieser Ausgabeform größer und bilden somit ein stärkeres Störspektrum im Hörbereich als bei der Ausgabeform nach Fig. 11.

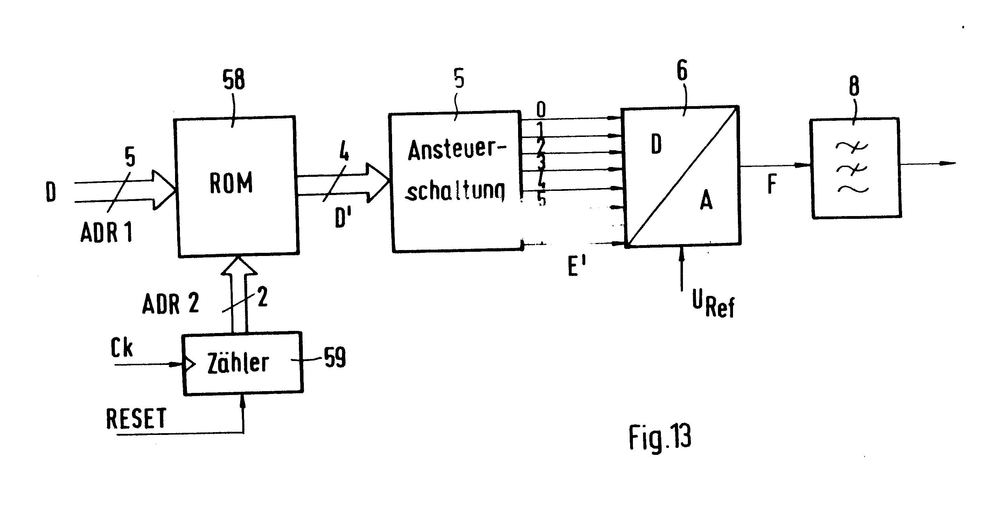

Aus Fig. 13 ist eine Reduktionsschaltung ersichtlich, mit der die Anzahl der Quantisierungsstufen verringert und die Impulsausgabeformen nach den Figuren 11 und 12 realisiert werden können. Sie ist der beschriebenen Ansteuerschaltung 5 (s.a. Fig. 1 und Fig. 5) vorgeschaltet. Die Eingangsdaten bilden eine Teiladresse ADR1 eines ROM-Speichers 58. Die zu einem Datenwert D(K) gespeicherten vier Impulsamplitudenwerte werden über eine 2-Bit-Teiladresse ADR2 von einem zyklisch durchlaufenden Zähler 59 angesteuert. Dessen Taktfrequenz CK entspricht der vierfachen Datenrate von D(K).

Zur Darstellung der neun Quantisierungsstufen 0 bis 8 ist ein binäres Ausgangswort mit 4 Bit erforderlich. Ein Rücksetzimpuls RESET dient zur Markierung der richtigen Anfangsposition des Zählers 59 beim Wechsel der Eingangsdaten D(K).

## Ansprüche

1. Schaltungsanordnung zum Umwandeln von digitalen Tonsignalwerten in ein analoges Tonsignal, die folgende Merkmale aufweist:

a. Ein Interpolationsfilter (3), in dem die ankommenden Signalwerte (A) in eine Folge interpolierter Signalwerte (B) mit einer erhöhten Folgefrequenz (Ü.$f_s$) umgesetzt werden,

b. eine Reduktionsschaltung (4), durch die die Wortlänge der interpolierten Signalwerte (B) verringert wird, und die aus einem Quantisierer (4a), einem Fehlerfilter (25) und einer Addierstufe (26) besteht,

c. ein Digital-Analog-Wandler,

c.c der aus mehreren nicht gewichteten Schaltstufen (16, 17) besteht, deren Teilströme ausgangsseitig addiert werden,

d. eine Ansteuerschaltung (5), durch die aufgrund der digitalen Signalwerte (D) am Ausgang des Quantisierers (4) die Schaltstufen (16, 17) derart gesteuert werden, daß die Summe der ausgegebenen Teilströme dem jeweils anliegenden Signalwert (D) entspricht und die dabei aktivierten Schaltstufen (16, 17) durch zyklische Weiterschaltung ausgewählt werden, und

e. ein dem Digital-Analog-Wandler (7) nachgeschalteter Tiefpaß (8), an dessen Ausgang das Analogsignal abgegeben wird.

2. Schaltungsanordnung nach Anspruch 1, bei der der Digital-Analog-Wandler (6) mindestens zwei Schaltstufen (16, 17) aufweist, so daß von ihr Impulse mit mindestens drei verschiedenen Amplitudenwerten ausgegeben werden.

3. Schaltungsanordnung nach Anspruch 1, bei der durch die einzelnen Schaltstufen (16, 17) je ein Teilstrom auf einen Summenpunkt (39) durchgeschaltet wird.

4. Schaltungsanordnung nach Anspruch 3, bei der die Schaltstufen aus untereinander gleichen parallelen Widerständen (16) bestehen, die jeweils durch einen Schalter (17) mit dem invertierenden Eingang eines gegengekoppelten Operationsverstärkers (18) verbunden werden.

5. Schaltungsanordnung nach Anspruch 3, bei der die Schaltstufen aus untereinander gleichen Stromquellen (20) bestehen, die jeweils durch einen Schalter (17) mit dem invertierenden Eingang eines gegengekoppelten Operationsverstärkers (18) verbunden werden.

6. Schaltungsanordnung nach Anspruch 5, dadurch gekennzeichnet, daß alle Stromquellen (20) mittels einer Bezugsspannung ($U_{ref}$) steuerbar sind.

7. Schaltungsanordnung nach Anspruch 1, deren Ansteuerschaltung aufweist:
- einen Akkumulator, der aus einem die Wortbreite der eingehenden digitalen Signalwerte aufweisenden Addierer (41) und einem diesem nachgeschalteten Verzögerungsglied (42) besteht, sowie
- einen ROM-Speicher (38), dessen Adressen von den eingehenden Signalwerten und den Ausgangswerten des Akkumulators gebildet werden, und dessen Ausgangsdaten die Schaltstufen (16, 17) zyklisch weiterschaltend steuern.

8. Schaltungsanordnung nach Anspruch 1, deren Ansteuerschaltung aufweist:
- einen ersten Decoder (44), durch den die eingehenden digitalen Signalwerte (mit n Bits) in einen Code m aus $2^n$ gewandelt werden,
- einen zweiten Decoder (45), durch den die eingehenden und in einem Akkumulator (41, 42) aufsummierten digitalen Signalwerte in einen Code 1 aus $2^n$ gewandelt werden, sowie
- $2^n$ Schalterblöcke (46, 47, 48), die jeweils von den Ausgängen des zweiten Decoders (45) gesteuert werden und in durchgesteuertem Zustand die Ausgänge des ersten Decoders (44) mit jeweils anderen Schaltstufen (16, 17) verbinden.

9. Schaltungsanordnung nach Anspruch 1, deren Ansteuerschaltung aufweist:
- einen Decoder (51), durch den die eingehenden digitalen Signalwerte in einen Code m aus $2^n$ umgewandelt werden,
- ein als Ringzähler arbeitendes Schieberegister (50), das von den Ausgängen des Decoders (51) gesetzt wird,
- einen Akkumulator (53, 54), durch den die eingehenden Signalwerte aufsummiert und um einen Taktzyklus verzögert werden,
- einen n + 1-Bit-Zähler (55) und ein UND-Gatter (57), durch die die parallelen Ausgangswerte des Akkumulators (53, 54) in serielle Schiebetakte für das Schieberegister (50) umgewandelt werden,
- ein Register (56), in das der Inhalt des Schieberegisters (50) nach Ende des Verschiebens eingespeichert wird und durch dessen Ausgänge die Schaltstufen (16, 17) des Digital-Analog-Wandlers (6) gesteuert werden, und
- einen Rücksetzeingang (RESET), über den alle Speicherzellen des Schieberegisters (50) auf Null gesetzt werden, bevor ein neuer digitaler Signalwert in das Schieberegister (50) parallel eingeschrieben wird.

10. Schaltungsanordnung nach Anspruch 1 mit einer weiteren Reduktionsschaltung (Fig. 13), in der jeder eingehende Signalwert (D) in eine Anzahl von r digitalen Teilwerten ($D_i'$) gewandelt wird, deren Summe gleich dem Signalwert (D) ist und die der Ansteuerschaltung (5) zugeführt werden.

11. Schaltungsanordnung nach Anspruch 10, bei der die Teilwerte und die Lage der Teilwerte so gewählt werden, daß das durch ihre Zeitfehler verursachte Störspektrum im Hörbereich ein Minimum aufweist.

12. Schaltungsanordnung nach Anspruch 10, die einen ROM-Speicher (58) aufweist
- dem als erste Teiladresse (ADR1) die eingehenden Signalwerte (D) zugeführt werden,
- dem als zweite Teiladresse (ADR2) der Zählerstand eines zyklisch durchlaufenden Zählers (59) zugeführt wird,
- und dessen Datenausgänge mit den Eingängen
der Ansteuerschaltung (5) verbunden sind.

Fig.1

Fig.2

Fig.3

D ( K )

22

| 1 | 1 | 1 | 1 | 0 | 0 | 0 | 0 |
|---|---|---|---|---|---|---|---|

D (1) = 4

| 0 | 1 | 2 | 3 | 4 | 5 | 6 | 7 |
|---|---|---|---|---|---|---|---|
| 0 | 0 | 0 | 0 | 1 | 1 | 1 | 0 |

D (2) = 3

| 1 | 1 | 1 | 1 | 0 | 0 | 0 | 1 |
|---|---|---|---|---|---|---|---|

D (3) = 5

| 0 | 0 | 0 | 0 | 1 | 1 | 0 | 0 |
|---|---|---|---|---|---|---|---|

D (5) = 2

Fig.4

Fig.5

fs = 32 kHz

Fig. 6

Fig.7

Fig.8

Fig.9

Fig.10

PAM

Fig.11

PAM + PDM

Fig.12

PAM + PWM

Fig.13